# EUROPEAN PATENT APPLICATION

(11) **EP 4 832 323 A1**
(43) Date of publication of application: **28.10.2026**
(21) Application number: 26174172.2
(22) Date of filing: 23.04.2026
(51) Int. Cl.: H02M 1/00, H02M 1/32, H02M 3/158, H04R 17/00

(54) **DC POWER SUPPLY AND METHOD THEREOF**

(30) Priority: 26.04.2025 US 202563795364 P; 21.04.2026 US 202619654392
(71) Applicant: Xmems Labs, Inc., Santa Clara, CA 95051 (US)
(72) Inventor: Liu, Jing-Meng, San Jose, 95129 (US); Lin, Yu-Chun, Tainan City 710 (TW); Huang, Hung-Chi, Taoyuan City 330 (TW)
(74) Representative: Straus, Alexander

(57) **Abstract**

A direct current power supply, configured to provide an output voltage (Vout) to a system, comprises a power stage, configured to output the output voltage (Vout); a difference block, configured to generate an error signal (e) by comparing a feedback signal (FB) corresponding to the output voltage (Vout) with a reference voltage (VREF); and a controller, configured to generate a control signal to control the power stage to attain the output voltage (Vout) according to the error signal, the controller comprising an integer determining block, configured to determine an integer according to the error signal; wherein the control signal has a switching frequency (FSW); wherein the system operates at a system operating frequency; wherein the switching frequency (FSW) is the integer times the system operating frequency.

## Description

### Field of the Invention

The present application relates to a DC power supply, and more particularly, to a DC power supply synchronous to applied system.

### Background of the Invention

Unless otherwise indicated herein, the approaches described in this section are not prior art to the claims in this application and are not admitted as prior art by inclusion in this section.

Direct current (DC) power supply or switching mode power supply (SMPS) has been used/applied in various systems, including sound producing system. During the operation of DC power supply or SMPS, ripple noise or other kind of noise would likely be brought into the applied system.

For sound producing system, especially the system producing sound by generating ultrasonic pulses, (ripple) noise may have beating with the operating frequency, where one of the beat frequency of noise may fall into the audible spectrum and degrade sound producing performance.

Therefore, it is necessary to improve the prior art.

### Summary of the Invention

It is therefore a primary objective of the present application to provide a DC power supply synchronous to the applied system, to improve over disadvantages of the prior art.

An embodiment of the present application discloses a direct current (DC) power supply configured to provide an output voltage to a system. The DC power supply comprises a power stage, configured to output the output voltage; a difference block, configured to generate an error signal by comparing a feedback signal corresponding to the output voltage with a reference voltage; a controller, configured to generate a control signal to control the power stage to attain the output voltage according to the error signal, the controller comprising an integer determining block, configured to determine an integer according to the error signal; wherein the control signal has a switching frequency; wherein the system operates at a system operating frequency; wherein the switching frequency is the integer times the system operating frequency.

An embodiment of the present application discloses a direct current (DC) power supply configured to provide an output voltage to a system. The DC power supply comprises a power stage, configured to output the output voltage, comprising a plurality of sub-power-stages; a difference block, configured to generate an error signal by comparing a feedback signal corresponding to the output voltage with a reference voltage; a controller, configured to generate a control signal to control the power stage to attain the output voltage according to the error signal, the controller comprising a percentage determining block, configured to determine a percentage of active sub-power-stages according to the error signal.

An embodiment of the present application discloses a method applied for a switching mode power supply (SMPS), wherein the SMPS is configured to provide an output voltage to a system. The method comprises generating an error signal according to the output voltage; and adjusting a switching frequency of the SMPS according to the error signal; wherein the switching frequency is synchronous to a system operating frequency of the system.

### Brief Description of the Drawings

FIG. 1 is a schematic diagram of a DC power supply according to an embodiment of the present application.
FIG. 2 is a schematic diagram of a DC power supply according to an embodiment of the present application.
FIG. 3 is a schematic diagram of waveforms corresponding to the DC power supply in FIG. 2.
FIG. 4 is a schematic diagram of an integer determining block according to an embodiment of the present application.
FIG. 5 is a schematic diagram of a power stage according to an embodiment of the present application.
FIG. 6 is a schematic diagram of a power stage according to an embodiment of the present application.
FIG. 7 is a schematic diagram of a power stage according to an embodiment of the present application.
FIG. 8 is a schematic diagram of a percentage determining block according to an embodiment of the present application.
FIG. 9 is a schematic diagram of a clamping circuit according to an embodiment of the present application.
FIG. 10 is a schematic diagram of a clamping circuit according to an embodiment of the present application.
FIG. 11 is a schematic diagram of a clamping circuit according to an embodiment of the present application.
FIG. 12 is a schematic diagram of an amplifying circuit according to an embodiment of the present application.
FIG. 13 is a schematic diagram of an amplifying circuit according to an embodiment of the present application.
FIG. 14 illustrates a schematic diagram of an air pulse generating device according to an embodiment of the present application.
FIG. 15 is a schematic diagram of waveforms of driving signals for the air pulse generating device in FIG. 14.

### Detailed Description

The technical features described in the following embodiments may be mixed or combined in various ways as long as there are no conflicts between them.

In the present invention, the term "coupled to" may refer to direct or indirect connection. "Component A being coupled to component B" may indicate that component A is directly connected to component B, or component A is connected to component B via some component C.

Direct current (DC) power supply or switching mode power supply (SMPS) is configured to provide a DC power/voltage to a system (e.g., sound producing system), where the DC power supply operates on a switching frequency and the system operates at a system operating frequency.

In the present application, the terms "DC power supply" and "SMPS" are used interchangeably.

In the present invention, the switching frequency of the DC power supply is constrained to be synchronous to the system operating frequency. In this case, there would be no beat frequency fall within audible band, therefore the sound producing performance is enhanced.

Furthermore, the present invention constrains the switching frequency to be an integer multiple of the system operating frequency and utilizes a feedback control loop to determine/adjust the integer multiple of the switching frequency. Hence, the DC power supply may operate at various switching frequencies and all switching frequencies are synchronous to the system operating frequency.

In the present invention, two frequencies being synchronous to/with each other refers that a first frequency *f*₁ is a rational multiple of a second frequency *f*₂, i.e., *f*₁ = (N/M) × *f*₂, where N, M are integers. In a special case of M = 1, the first frequency *f*₁ being synchronous to the second frequency *f*₂ means the first frequency *f*₁ is an integer multiple of the second frequency*f*₂.

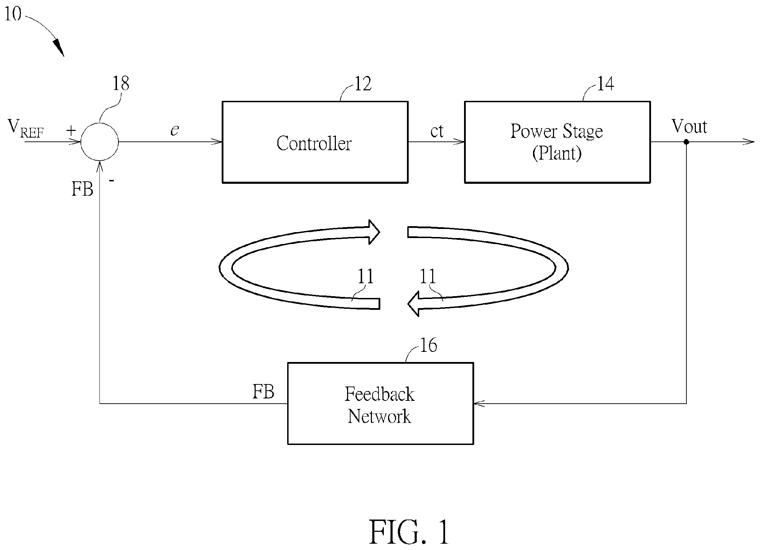

FIG. 1 is a schematic diagram of a DC power supply 10 according to an embodiment of the present application. The DC power supply 10 is an SMPS, which is configured to provide an output voltage Vout to a system (e.g., an air pulse generating system). The (air pulse generating) system may operate at a system operating frequency F_{sys}, which may be ultrasonic frequency. The DC power supply 10 comprises a controller 12, a power stage 14, a feedback network 16 and a difference block 18, forming a feedback control loop 11. The power stage 14, which may be considered as a plant of the feedback control loop, outputs electric current to a load (not shown in FIG. 1, where the load may be a driving circuit of the system), so as to output the output voltage Vout. In an embodiment, the power stage 14 may be a DC-DC converter/circuit (e.g., a buck-boost converter) controlled by a PWM (PWM: pulse width modulation) control signal, for example.

The output voltage Vout would be feedback to the difference block 18 via the feedback network 16 as a feedback signal FB. The difference block 18 compares the feedback signal FB with a reference voltage V_{REF} and generates an error signal e. The controller 12 generates a control signal ct according to the error signal *e* to control the plant, i.e., the power stage 14, such that the output voltage Vout would achieve/attain a specified target voltage V_{TARGET}.

For example, the controller 12 may be configured to generate a PWM control signal to control the plant, i.e., the power stage 14, according to the error signal e. Note that, the PWM control signal has a switching frequency F_{SW}, which is a frequency of the pulses within the PWM control signal. Meanwhile, the output voltage Vout would be proportional to electric charges injected to the load. The higher the switching frequency F_{SW}, the higher the output voltage Vout expected to be (assuming other conditions remain the same). In this regard, the controller 12 may be configured to determine the switching frequency F_{SW} and generate the PWM control signal with the switching frequency F_{SW}, so that the output voltage Vout would achieve/attain the specified target voltage V_{TARGET}.

Furthermore, in order to mitigate effect brought by ripple noise and other kinds of noise causing on the system, in the present invention, the switching frequency F_{SW} is suggested to be integer multiple of the system operating frequency F_{sys} of the system, i.e., F_{SW} = N × F_{sys}, where N is an integer.

In an embodiment, the controller 12 may be configured to determine the integer N according to the error signal *e*, so as to generate the PWM control signal with the switching frequency F_{SW} to achieve/attain the specified target voltage V_{TARGET}, where F_{SW} = N × F_{sys}.

In addition, the power stage 14 may comprise a plurality of sub-power-stages, where a summation of a plurality of sub-currents output from the sub-power-stages may be the current output from the entire power stage 14.

In an embodiment, the controller 12 may be configured to determine a percentage of active/enabled sub-power-stages according to the error signal *e,* so that the output voltage Vout may achieve/attain the specified target voltage V_{TARGET}.

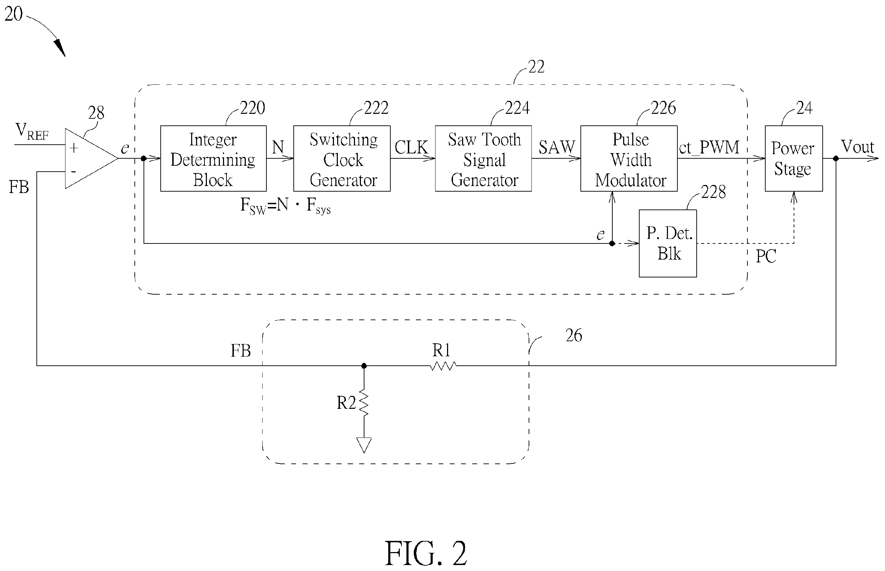

Specifically, FIG. 2 is a schematic diagram of a DC power supply 20 according to an embodiment of the present application. The DC power supply 20 is also a SMPS, which comprises a controller 22, a power stage 24 and a feedback network 26 and a difference block 28.

The difference block 28 may be an (operational) amplifier.

The feedback network 26 may be a voltage divider or a resistor divider network, where $FB = \frac{R 2}{R 1 + R 2}$ Vout. In this case, the target voltage V_{TARGET} may be regarded as V_{TARGET} = (1+ R1/R2) V_{REF}.

The controller 22 is configured to generate a PWM control signal ct_PWM (a kind of control signal ct) according to the error signal *e*. The controller 22 comprises a switching clock generator 222, a sawtooth signal generator 224 and a pulse width modulator 226. The switching clock generator 222 configured to generate a switching clock CLK with the switching frequency F_{SW}, where F_{SW} = N × F_{sys}. The sawtooth signal generator 224 is configured to generate a sawtooth signal SAW with the switching frequency F_{SW} according to the switching clock CLK. The pulse width modulator 226 is configured to generate the PWM control signal ct_PWM according to the sawtooth signal SAW and the error signal e.

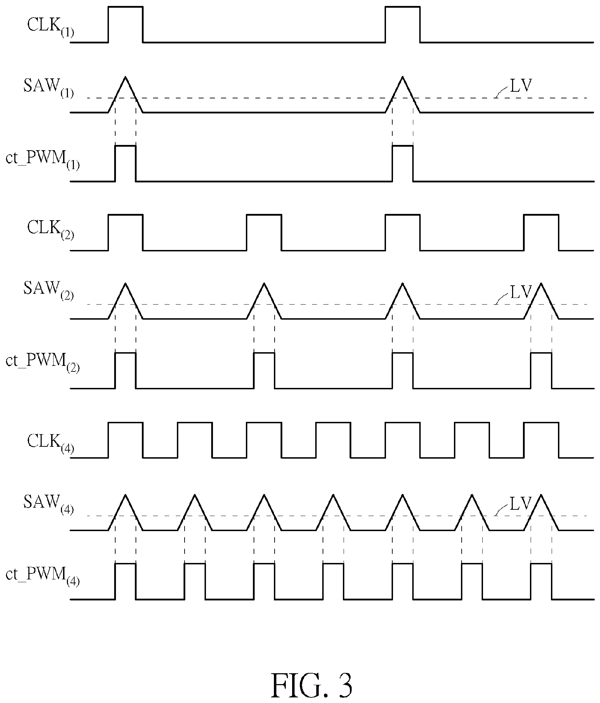

Waveforms of the switching clock CLK, the sawtooth signal SAW and the PWM control signal ct_PWM are illustrated in FIG. 3. Specifically, in FIG. 3, CLK_{(N)}, SAW_{(N)} and ct_PWM_{(N)} represent signals corresponding to integer N, where F_{SW} = N × F_{sys} or F_{SW, (N)} = N × F_{sys}, and F_{SW, (N)} represents the switching frequency corresponding to integer N.

In other words, the switching clock generator 222 and the sawtooth signal generator 224 generate the switching clock CLK_{(N)} and the sawtooth signal SAW_{(N)}, respectively, with the switching frequency F_{SW, (N)}.The pulse width modulator 226 generates the PWM control signal ct_PWM_{(N)} according to a level LV, where the level LV is related/proportional to the error signal e (shown in FIG. 1 or FIG. 2). In an embodiment, the larger the error signal e, the lower the level LV and the wider the PWM control signal width; consequently, more charge is delivered to the load.

To adjust the charge delivered to the load, in addition to the level LV determined within the pulse width modulator 226 according to error signal e, another factor is the switching frequency. Furthermore, under the constraint of F_{SW, (N)} = N × F_{sys}, a factor to adjust the charge delivered to the load would be the integer N.

In the present invention, the controller 22 comprises an integer determining block 220 to determine the integer N according to the error signal *e.* In general, the integer determining block 220 may increase the integer N when the error signal *e* is too large or greater than a first threshold (denoted as, e.g., PDV1); on the other hand, the integer determining block 220 may decrease the integer N when the error signal *e* is too small or less than a second threshold (denoted, e.g., PDV2 and PDV2 < PDV1).

Moreover, in an embodiment, the integer determining block 220 may increase the integer N by at least a first increment n₁ when the error signal e is greater than the first threshold (PDV1), and the integer determining block 220 may increase the integer N by a second increment n₂ when the error signal *e* is greater than a third threshold (denoted as, e.g., PDV0), where PDV0 > PDV1 and n₂ > n₁.

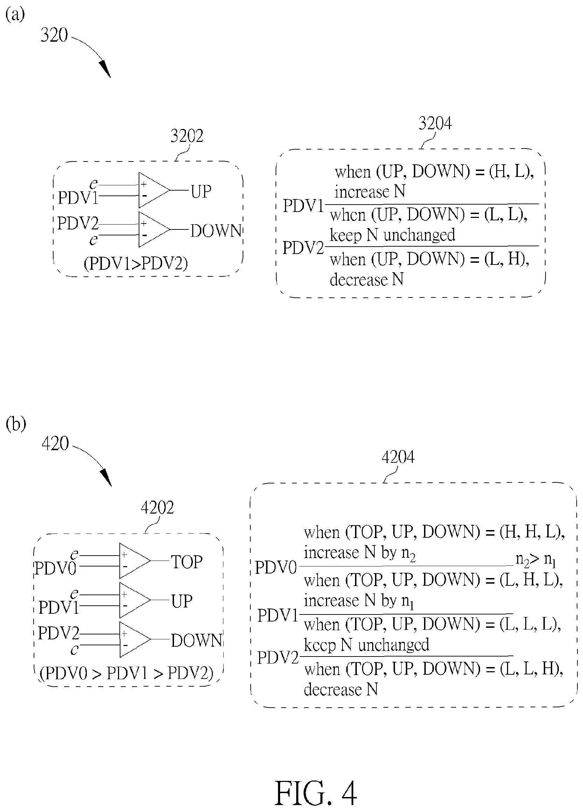

FIG. 4 is a schematic diagram of an integer determining block according to an embodiment of the present application. Specifically, FIG. 4(a) and FIG. 4(b) are schematic diagrams of an integer determining block 320 and an integer determining block 420, respectively, according to embodiments of the present application. The integer determining block 320/420 may be used to realize the integer determining block 220 stated in the above.

The integer determining block 320/420 may comprise an error signal classification block 3202/4202 and a determining block 3204/4204. The error signal classification block 3202/4202 comprises two/three comparators and outputs two/three comparison results (UP, DOWN) / (UP, DOWN, TOP). According to the two/three comparison results (UP, DOWN) / (UP, DOWN, TOP), the determining block 3204/4204 may determine whether to increase/decrease the integer N according to the comparison results (UP, DOWN) / (UP, DOWN, TOP).

The integer determining block of the present invention can be realized by either analog circuit or digital circuit, or both. In FIG. 4, the error signal classification block 3202/4202 shows analog part (which comprises comparators or op-amps (op-amp: operational amplifier)) and the determining block 3204/4204 shows logic/control part (which may be realized by digital synthesized circuit, but not limited thereto).

Note that, the integer determining block 420 having piecewise/stepwise adjustment may have better tracking capability, compared to the integer determining block 320, especially when the feedback signal FB is far behind/below the reference voltage V_{REF}. Hence, the DC power supply, equipped with an integer-determining block with piecewise/stepwise adjustment, achieves a faster transient response to Vout variations.

Note that the piecewise/stepwise adjustment shown in FIG. 4(b) is carried out in an incremental direction; however, it is not limited thereto. The adjustment may also be implemented in the opposite decremental direction, which also falls within the scope of the present invention.

For the decremental direction, in addition to decreasing the integer N, it is possible to decrease a percentage of the current output by the output stage. Note that, the power stage (or the buck-boost converter) may be realized by a plurality of sub-sections or a plurality of sub-power-stages. Controlling the percentage of active/enabled sub-power-stages would have finer granularity in terms of adjusting output current which brings the output voltage Vout.

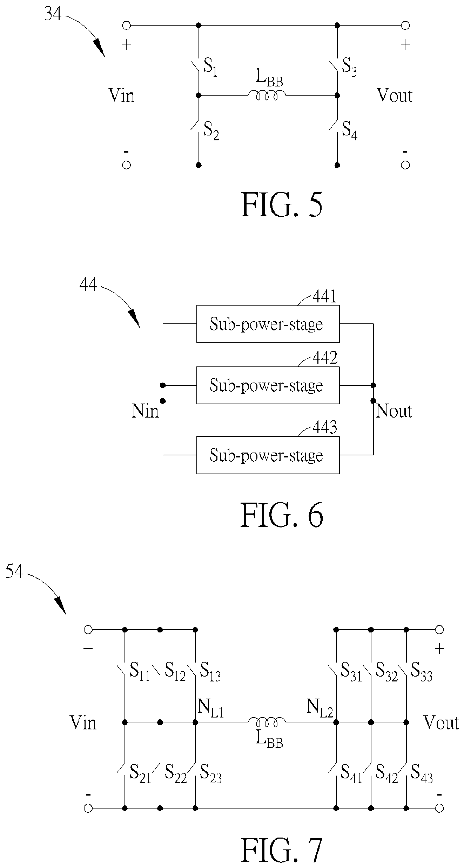

A basic structure of the power stage is first described below. FIG. 5 is a schematic diagram of a power stage 34 according to an embodiment of the present application. The power stage 34 is a 4-switch buck-boost converter, which comprises an inductor L_{BB} and switches S1-S4. The switches S1-S4 are controlled by or according to the PWM control signals (e.g., ct_PWM and/or its deviation(s)) generated from the pulse width modulator 226. Details of control mechanisms between the PWM control signals and the buck-boost converter are known in the art, which are not narrated herein for brevity.

As mentioned earlier, power stage can be further segmented/realized by a plurality of sub-sections or a plurality of sub-power-stages. FIGs. 6 and 7 are schematic diagrams of power stages 44 and 54, respectively, according to embodiments of the present application. The power stage 44 can be viewed as an abstract representation of the power stage 54. The power stage 44 comprises sub-power-stages 441-443, which are connected in parallel. The power stage 54 has basic circuit structure of 4-switch buck-boost converter or the power stage 44. The power stage 54 can be viewed as a segmented 4-switch buck-boost converter, which comprises switches S₁₁-S₁₃, S₂₁-S₂₃, S₃₁-S₃₃, S₄₁-S₄₃.

In an abstract point of view, the power-stages 441-443 are connected in parallel between two representative terminals Nin and Nout shown in FIG. 6. In fact, the interconnecting nodes (N_{L1}, N_{L2}) between the switches and the inductor as well as the inductor L_{BB} shown in FIG. 7 are omitted in FIG. 6.

The term "segmented" refers to a configuration where the power stage is partitioned into a plurality of parallel-connected sub-units, allowing the system to selectively enable a specific number of units to achieve finer control resolution.

The sub-power-stage 441 may be viewed as comprising a first set of switches S₁₁, S₂₁, S₃₁ and S₄₁, the sub-power-stage 442 may be viewed as comprising a second set of switches S₁₂, S₂₂, S₃₂ and S₄₂ and the sub-power-stage 443 may be viewed as comprising a third set of switches S₁₃, S₂₃, S₃₃ and S₄₃.

One set of switches, or namely, the first/second/third set of switches, and the inductor L_{BB} form an individual buck-boost converter. Combining/aggregating all sets of switches, i.e., combining/aggregating the first, second and third sets of switches form an aggregated buck-boost converter. An aggregated current produced by the aggregated buck-boost converter is a summation of all individual buck-boost converters.

In another perspective, a total current of the aggregated buck-boost converter, or namely, the power stage 44/54, can be reduced or adjusted (lower) by properly controlling the switches S₁₁-S₁₃, S₂₁-S₂₃, S₃₁-S₃₃, S₄₁-S₄₃.

In other words, a percentage of active/enabled sub-power-stages of the power stage may be controlled by the controller. For example, the controller 22 may control the power stage 44 such that only the sub-power-stage 441 is active/enabled (meaning that some switches within the sub-power-stage 441 are conducted and a current flows through the sub-power-stage 441), and the rest of the sub-power-stages 442 and 443 are inactive/disabled (meaning that no switch within the sub-power-stages 442 and 443 is conducted and no current flows through the sub-power-stages 442 and 443). In this case, suppose switches within the sub-power-stages 441-443 have equal size, then the percentage of active/enabled sub-power-stages of the power stage may be considered as 1/3.

In the above example, the percentage of active/enabled sub-power-stages of the power stage may be related to a number of active/enabled sub-power-stages, which is not limited thereto. Switches within different sub-power-stages may have different switches sizes and own different current-driving capability, providing additional degree of freedom to adjusting the percentage.

Specifically, switches within the sub-power-stages 441, 442, and 443 may have power switch sizes PSS1, PSS2, PSS3, respectively. Power switch size may be referred to the width of the power MOSFET (MOSFET: Metal-Oxide-Semiconductor Field-Effect Transistor). The more the size/width, the more the current conducted.

In an embodiment, the power switch sizes PSS1, PSS2, PSS3 may be the same, i.e., PSS1 = PSS2 = PSS3.

In an embodiment, the power switch sizes PSS1, PSS2, PSS3 may have binary relationships, e.g., PSS1: PSS2: PSS3 = 1: 2: 4. Controlling the activeness of the sub-power-stages may use or be related to binary representation of the percentage, and may achieve certain number of different percentages by fewer sub-power-stages or fewer control signals.

In an embodiment, the percentage of active/enabled sub-power-stages may be a ratio of the current provided by the active sub-power-stages to the total current capacity when all sub-power-stages are enabled. In other words, the percentage of active sub-power-stages may be represented by a ratio of a first current (associated with the active sub-power-stages) to a second current (corresponding to a state where all sub-power-stages are active).

In an embodiment, the controller 22 may determine a percentage PC of active/enabled sub-power-stages according to the error signal e. Specifically, the controller 22 may comprise a percentage determining block 228.

Note that, both the integer determining block 220 and the percentage determining block 228 are shown in FIG. 2. Preferably, the controller 22 comprises both the integer determining block 220 and the percentage determining block 228, which is not limited thereto. In an embodiment, the controller or the DC power supply of the present invention may comprise only one of the integer determining block and the percentage determining block, which is also within the scope of the present invention.

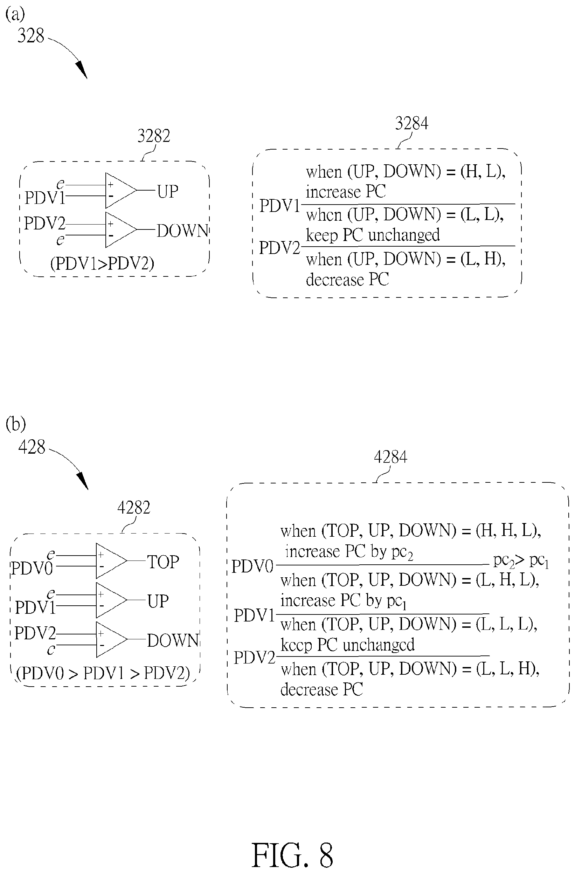

FIG. 8 is a schematic diagram of a percentage determining block according to an embodiment of the present application. Specifically, FIGs. 8(a) and 8(b) are schematic diagrams of a percentage determining block 328 and a percentage determining block 428 according to embodiments of the present application.

The percentage determining block 328/428 may comprise an error signal classification block 3282/4282 and a determining block 3284/4284. The error signal classification block 3282/4282 comprises two/three comparators and outputs two/three comparison results (UP, DOWN) / (UP, DOWN, TOP). According to the two/three comparison results (UP, DOWN) / (UP, DOWN, TOP), the determining block 3284/4284 may determine whether to increase/decrease the percentage PC of active/enabled sub-power-stages according to the comparison results (UP, DOWN) / (UP, DOWN, TOP).

The percentage determining block 328 may increase the percentage PC when the error signal e is too large or greater than a first threshold (e.g., PDV1); on the other hand, the percentage determining block 328 may decrease the percentage PC when the error signal e is too small or less than a second threshold (e.g., PDV2 and PDV2 < PDV1).

Moreover, the percentage determining block 428 may increase the percentage PC by at least a first increment pc₁ when the error signal e is greater than the first threshold (PDV1), and the percentage determining block 428 may increase the percentage PC by a second increment pc₂ when the error signal e is greater than a third threshold (denoted as, e.g., PDV0), where PDV0 > PDV1 and pc₂ > pc₁.

The percentage determining block 328/428 may have similar circuit structure to the integer determining block 320/420, which is not narrated herein for brevity.

In an embodiment, the integer determining block and the percentage determining block may share hardware circuit in common. For example, the error signal classification block 3202/4202 may share the hardware circuit (e.g., the comparators) with the error signal classification block 3282/4282
In FIG. 4 and FIG. 8, "TOP", "UP" and "DOWN" indicate comparison results according to which the integer N and the percentage PC is determined.

Since the switching frequency of the DC power supply is constrained to be synchronous to the (ultrasonic) system operating frequency, or specifically F_{SW} = N × F_{sys}, beat frequencies between the DC power supply and the applied system would be either at *f* = 0 or beyond audible band, which would not fall within audible band.

In addition, in order to prevent overshoots, i.e., the output voltage Vout exceeds the target voltage V_{TARGET} (too much), a clamping circuit may be included in the DC power supply.

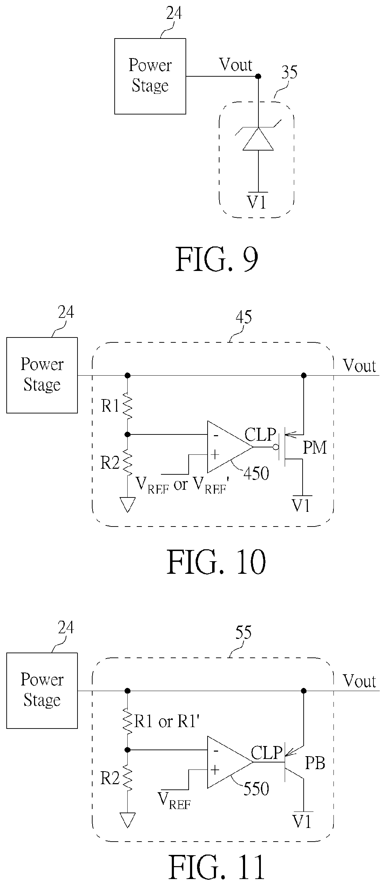

FIGs. 9, 10 and 11 are schematic diagrams of clamping circuits 35, 45 and 55, respectively, according to embodiments of the present application.

The clamping circuit 35 comprises a Zener diode with cathode coupled to a terminal of the output voltage Vout and anode coupled to a terminal of a voltage V1, where V1 may represent a constant voltage or a ground voltage. When the voltage Vout is significantly higher than the voltage V1, the Zener diode enters its breakdown region and a breakdown current is conducted, so as to reduce the output voltage Vout.

The clamping circuits 45 and 55 comprises a transistor with a control terminal coupled to an output terminal of an amplifier. In the embodiment shown in FIG. 10 and FIG. 11, the transistor is a P-type transistor (but not limited thereto), which is conducted when the voltage of the control terminal is sufficiently low. Specifically, the clamping circuit 45 comprises a PMOS (PMOS: P-channel MOSFET) PM and the clamping circuit 55 comprises a PNP BJT (BJT: Bipolar Junction Transistor) PB, which is not limited thereto.

An amplifier 450/550 is coupled to the P-type transistor PM/PB. A positive terminal of the amplifier 450/550 receives a first signal and a negative terminal of the amplifier 450/550 receives a second signal, where the first signal comprises the reference voltage V_{REF} and the second signal is proportional to the output voltage Vout. The amplifier 450/550 generates a clamping signal CLP to the P-type transistor PM/PB. When the output voltage Vout is too high/large or higher/larger than a threshold, the amplifier 450/550 generates the clamping signal CLP as a low voltage, and the P-type transistor PM/PB conducts, which reduces the output voltage Vout.

In an embodiment, the first signal received by the amplifier 450 may be the reference voltage V_{REF} or a voltage V_{REF}' with V_{REF}' = V_{REF} + V_{OS}, where V_{OS} represents an offset voltage of the amplifier 450, which is to compensate imperfect mismatch within the amplifier practically.

In an embodiment, a resistor R1' shown in FIG. 11 may be expressed as R1' = R1 + R1a, where R1a represents additional resistance to compensate practical imperfections, which is optional.

Note that, unavoidable mismatch exists between distinct (two) amplifiers. Such mismatch may cause the transistor in clamping circuit (e.g., PM or PB) to be conducted at the wrong time. Specifically, unavoidable mismatch may exist between the amplifier 28 within the feedback control loop and the amplifier 450/550 within the clamping circuit 45/55.

A remedy for such mismatch is to share the differential input stage between two amplifiers. Note that, op-amp comprises a differential input stage, an intermediate stage and an amplifier output stage. One amplifying circuit may comprise one differential input stage, one intermediate stage and multiple (e.g., two) amplifier output stages, where one of the amplifier output stages outputs the error signal e and another amplifier output stage outputs the clamping signal CLP.

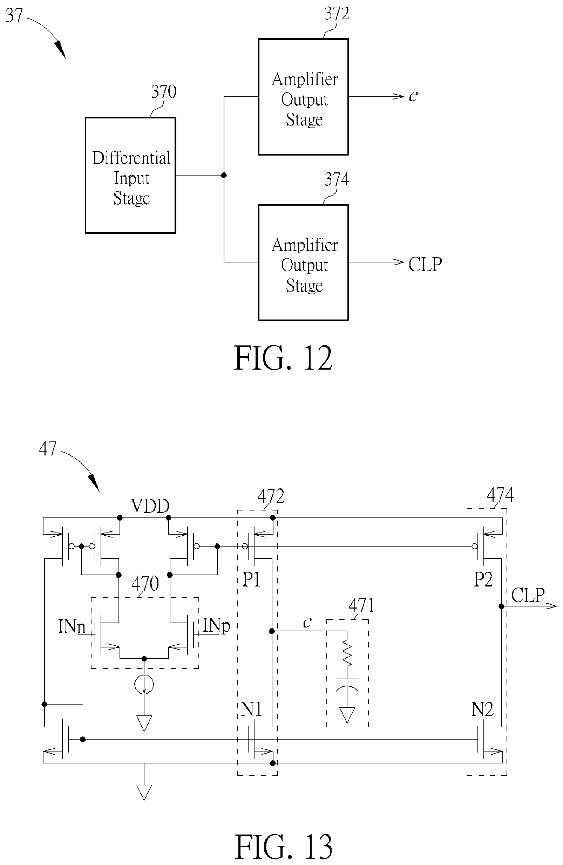

For example, FIG. 12 is a schematic diagram of an amplifying circuit 37 according to an embodiment of the present application. The amplifying circuit 37 comprises one differential input stage 370 and two amplifier output stages 372 and 374 (where intermediate stage is omitted for brevity). The two amplifier output stages 372 and 374 are coupled to the differential input stage 370, where the amplifier output stage 372 outputs the error signal e and the amplifier output stage 374 outputs the clamping signal CLP.

Specifically, FIG. 13 is a schematic diagram of an amplifying circuit 47 according to an embodiment of the present application. The amplifying circuit 47 is illustrated in transistor level, which can be used to realize the amplifying circuit 37. Similarly, the amplifying circuit 47 comprises one differential input stage 470 and two amplifier output stages 472 and 474 (where intermediate stage is shown and also shared). The two amplifier output stages 472 and 474 are coupled to the differential input stage 470, where the amplifier output stage 472 outputs the error signal *e* and the amplifier output stage 474 outputs the clamping signal CLP.

Note that, offset voltage may be mitigated by adjusting a ratio of transistor transconductance. For example, it can adjust the transistor conductance such that (gmp2/ gmn2) > (gmp1/ gmn1) to mitigate the offset voltage, where gmp1, gmn1, gmp2 and gmn2 represent transconductance of the transistors P1, N1, P2, N2, respectively.

In the embodiment shown in the amplifying circuit 47, a compensation circuit 471 comprising a capacitor and a resistor (functioning as a low pass filter) is included and coupled to the output terminal of the output voltage Vout. The compensation circuit 471 may be configured to filter/average out high frequency variation of the error signal e, which may stabilize system performance.

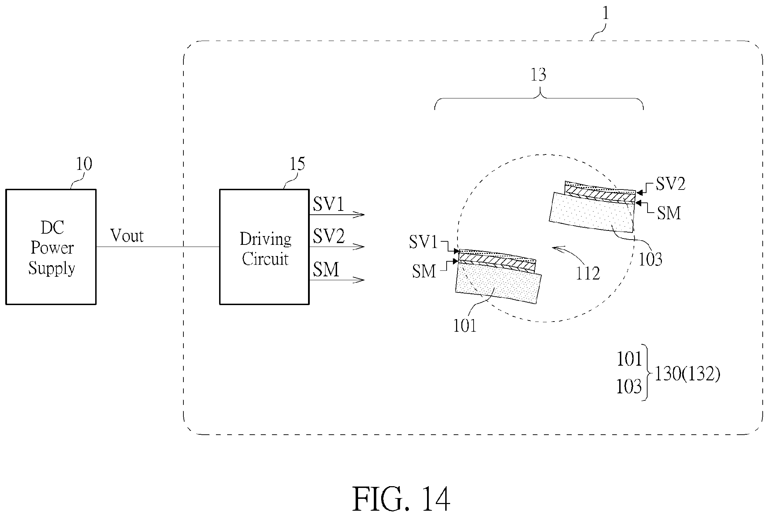

FIG. 14 illustrates a schematic diagram of an air pulse generating system 1 according to an embodiment of the present application. The air pulse generating system 1 comprises an air pulse generating device 13 and a driving circuit 15. The pulse generating device 13 comprises a film structure 130. The film structure 130 comprises a first flap 101 and a second flap 103, forming a flap pair 132.

The first flap 101 is driven by a first valve driving signal SV1 and the second flap 103 is driven by a second valve driving signal SV2, such that the flap pair 132 performs a differential mode movement to form a virtual valve 112.

Meanwhile, both the flaps 101 and 103 are driven by a pressure driving signal SM, such that the flap pair 132 performs a common mode movement to form an amplitude modulated air pressure variation.

The driving circuit 15 is configured to generate the pressure driving signal SM and the valve driving signal SV1 and SV2. The DC power supply 10, which generally refers to all kinds of DC power supply in the present invention, is configured to provide the voltage Vout to the driving circuit 15.

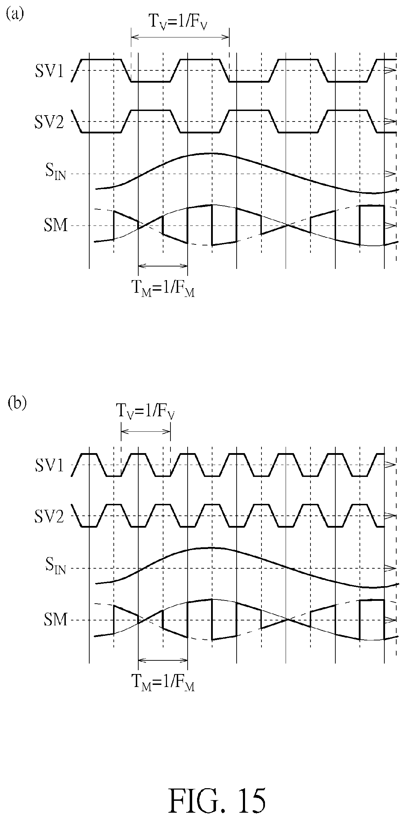

Waveforms of the driving signals SV1, SV2 and SM are illustrated in FIG. 15. In general, the valve driving signals SV1 and SV2 correspond to a valve driving frequency Fv, and the pressure driving signal SM corresponds to a pressure driving frequency F_{M}. FIG. 15(a) illustrates a scheme of F_{M} = 2·Fv (which may be referred to US Patent No. 11,943,585), and FIG. 15(b) illustrates a scheme of F_{M} = Fv (which may be referred to US Application No. 19/424,094). In any case, the system operating frequency F_{sys} of the air pulse generating system 1 can be chosen as the pressure driving frequency F_{M}, or the valve driving frequency Fv.

Suppose F_{sys} = F_{M}, the switching frequency F_{SW} of the switching mode power supply (SMPS) or the DC power supply (e.g., 10) would be F_{SW} = N·F_{M}. Consequently, the switching ripple and other noises generated by the SMPS are synchronized with the system operating frequency F_{sys} or the pressure driving frequency F_{M}. The impact of the switching noise remains *temporally consistent* across a plurality of system operating cycles, whether during the valve driving cycle T_{V} or the pressure driving cycle T_{M}.

In the present application, the multiplication symbols "×" and "." are used interchangeably.

In other words, synchronizing the switching frequency F_{SW} with the system operating frequency F_{sys} does *not inherently eliminate switching noise* of the SMPS. Instead, it ensures that the switching ripple remains consistent across/over system operating cycles. By constraining F_{SW} to be synchronous with F_{sys}, the *impact of the switching noise* is significantly and *effectively reduced* from the perspective of the system's synchronized operation or sampling. Therefore, system performance would be enhanced.

When the air pulse generating system 1 is applied for sound producing, synchronizing the switching frequency F_{SW} with the (ultrasonic) system operating frequency F_{sys} generates no beat frequency within audible band, thereby sound quality is improved.

In summary, by synchronizing the switching frequency with the system operating frequency, the disclosed DC power supply effectively mitigates the impact of switching noise. This synchronized approach ensures a stable power provision, thereby enhancing the overall performance of the applied system.

## Claims

1. A direct current, abbreviated as DC hereafter, power supply, configured to provide an output voltage (Vout) to a system, the DC power supply **characterised by** comprising:
a power stage, configured to output the output voltage (Vout);
a difference block, configured to generate an error signal (e) by comparing a feedback signal (FB) corresponding to the output voltage (Vout) with a reference voltage (V_{REF}); and
a controller, configured to generate a control signal to control the power stage to attain the output voltage (Vout) according to the error signal, the controller comprising:
an integer determining block, configured to determine an integer according to the error signal;
wherein the control signal has a switching frequency (F_{SW});
wherein the system operates at a system operating frequency;
wherein the switching frequency (F_{SW}) is the integer times the system operating frequency.

2. The DC power supply of claim 1, **characterised in that**
the integer determining block increases the integer when the error signal is greater than a first threshold (PDV1), the integer determining block decreases the integer when the error signal is less than a second threshold (PDV2), and the first threshold (PDV1) is greater than the second threshold (PDV2); or
the integer determining block increases the integer by at least a first increment when the error signal is greater than the first threshold, the integer determining block increases the integer by a second increment when the error signal is greater than a third threshold (PDV0), the second increment is greater than the first increment, and the third threshold (PDV0) is greater than the first threshold (PDV1).

3. The DC power supply of claim 1, **characterised in that**
the power stage comprises a plurality of sub-power-stages, and the controller comprises a percentage determining block, configured to determine a percentage of active sub-power-stages according to the error signal;
the percentage determining block increases the percentage of active sub-power-stages when the error signal is greater than a first threshold (PDV1), the percentage determining block decreases the percentage of active sub-power-stages when the error signal is less than a second threshold (PDV2), and the first threshold (PDV1) is greater than the second threshold (PDV2); or
the percentage determining block increases the percentage of active sub-power-stages by at least a first increment when the error signal is greater than the first threshold, the percentage determining block increases the percentage of active sub-power-stages by a second increment when the error signal is greater than a third threshold (PDV0), the second increment is greater than the first increment, and the third threshold (PDV0) is greater than the first threshold (PDV1).

4. The DC power supply of claim 1, **characterised by** further comprising a clamping circuit coupled to an output terminal of the DC power supply, wherein the clamping circuit comprises a Zener diode.

5. The DC power supply of claim 1, **characterised by** further comprising a clamping circuit coupled to an output terminal of the DC power supply,
the clamping circuit comprises a first switch, the first switch is conducted when the output voltage (Vout) is larger than a threshold, and a control terminal of the first switch is coupled to an amplifier; and
the amplifier receives a first signal and a second signal, the first signal comprises the reference voltage (V_{REF}), and the second signal is proportional to the output voltage (Vout).

6. The DC power supply of claim 5, **characterised in that**
the first switch is a P-type switch, the amplifier comprises a positive input terminal, a negative input terminal and an output terminal, the amplifier receives the first signal at the positive input terminal and receives the second signal at the negative input terminal, the output terminal of the amplifier is coupled to a control terminal of the P-type switch, and the amplifier produces a clamping signal to the control terminal of the P-type switch; and
the first signal comprises the reference voltage (V_{REF}) and an offset voltage (V_{OS}).

7. The DC power supply of claim 1, **characterised by** further comprising:
an amplifying circuit, comprising a differential input stage, a first amplifier output stage and a second amplifier output stage;
wherein the first amplifier output stage outputs the error signal (*e*);
wherein the switching frequency is determined according to the error signal;
wherein the second amplifier output stage outputs a clamping signal (CLP) for a switch of a clamping circuit;
wherein the difference block comprises a first amplifier, configured to compare a feedback signal (FB) with the reference voltage (V_{REF}) and generate the error signal (*e*);
wherein the first amplifier comprises the differential input stage and the first amplifier output stage;
wherein the DC power supply comprises the clamping circuit, the clamping circuit comprises a second amplifier, and the second amplifier comprises the differential input stage and the second amplifier output stage.

8. The DC power supply of claim 1, **characterised in that** the difference block comprises an amplifier.

9. The DC power supply of claim 1, **characterised in that** the controller comprises:
a switching clock generator, configured to generate a switching clock with the switching frequency (F_{SW}), wherein the switching frequency (F_{SW}) is the integer times the system operating frequency;
a sawtooth signal generator, configured to generate a sawtooth signal with the switching frequency (F_{SW}) according to the switching clock; and
a pulse width modulator, configured to generate a PWM control signal according to the sawtooth signal and the error signal;
wherein the PWM control signal has the switching frequency (F_{SW});
wherein the power stage is controlled by the PWM control signal, so as to output the output voltage (Vout).

10. The DC power supply of claim 1, **characterised in that** the controller comprises an error signal classification block, the error signal classification block comprises:
a first comparator, configured to compare the error signal with a first threshold (PDV1) and generate a first comparison result (UP); and
a second comparator, configured to compare the error signal with a second threshold (PDV2) and generate a second comparison result (DOWN);
wherein the controller determines the integer or a percentage of active sub-power-stages according to the first comparison result and the second comparison result.

11. The DC power supply of claim 10, **characterised in that** the error signal classification block further comprises:
a third comparator, configured to compare the error signal with a third threshold (PDV0) and generate a third comparison result;
wherein the controller determines the integer or a percentage of active sub-power-stages according to the first comparison result, the second comparison result and the third comparison result.

12. The DC power supply of claim 1, **characterised in that**
the system is an air pulse generating system, the air pulse generating system comprises a driving circuit and an air pulse generating device, and the pulse generating device comprises a film structure;
wherein the DC power supply provides the output voltage (Vout) for the driving circuit;
wherein the driving circuit drives the film structure to operate at the system operating frequency;
wherein the film structure comprises a first flap and a second flap;
wherein the driving circuit generates a first valve driving signal to drive the first flap and generates a second valve driving signal to drive the second flap;
wherein the first flap and the second flap perform a differential mode movement to form a virtual valve;
wherein the first valve driving signal and the second valve driving signal are synchronous with the system operating frequency;
wherein the switching frequency (F_{SW}) is the integer times the system operating frequency.

13. A method applied for a switching mode power supply, abbreviated as SMPS hereafter, wherein the SMPS is configured to provide an output voltage (Vout) to a system, the method **characterised by** comprising:
generating an error signal (e) according to the output voltage (Vout); and
adjusting a switching frequency (F_{SW}) of the SMPS according to the error signal (*e*);
wherein the switching frequency (F_{SW}) is synchronous to a system operating frequency of the system.

14. The method of claim 13, **characterised by** further comprising:
determining an integer according to the error signal;
wherein the switching frequency (F_{SW}) is the integer times the system operating frequency (F_{sys});
wherein the system operates at the system operating frequency.

15. The method of claim 14, **characterised in that**
the system is an air pulse generating system, the air pulse generating system comprises a driving circuit and an air pulse generating device, and the pulse generating device comprises a film structure;
wherein the driving circuit drives the film structure to operate at the system operating frequency;
wherein the film structure comprises a flap pair, the flap pair is driven by a valve driving signal to perform a differential mode movement and a pressure driving signal to perform a common mode movement;
wherein the valve driving signal has a valve driving frequency (F_{V}) and the pressure driving signal has a pressure driving frequency (F_{M});
wherein the switching frequency (F_{SW}) is an integer multiple of the valve driving frequency or an integer multiple of the pressure driving frequency.
